# EUROPEAN PATENT APPLICATION

(11) **EP 2 884 521 A1**
(43) Date of publication of application: **17.06.2015**
(21) Application number: 14195923.9
(22) Date of filing: 02.12.2014
(51) Int. Cl.: H01L 21/02, H01L 29/06, H01H 59/00, B81B 3/00, H01L 21/322

(54) **A silicon substrate suitable for use with an RF component, and an RF component formed on such a silicon substrate**

(30) Priority: 16.12.2013 US 201314108035
(71) Applicant: Analog Devices Global, Hamilton (BM)
(72) Inventor: Lambkin, Paul Martin, Norwood, MA Massachusetts 02062 (US); Fitzgerald, Padraig L., Norwood, MA Massachusetts 02062 (US); Stenson, Bernard Patrick, Norwood, MA Massachusetts 02062 (US); Goggin, Raymond C., Norwood, MA Massachusetts 02062 (US); Lynch, Seamus A., Norwood, MA Massachusetts 02062 (US); Lane, William A., Norwood, MA Massachusetts 02062 (US)
(74) Representative: Beck, Simon Antony

(57) **Abstract**

A silicon substrate is provided that may facilitate the formation of RF components more cheaply by using a silicon layer formed by the Czochralski process, and having a carrier life time killing layer deposited on the silicon layer.

## Description

### Field

The present invention relates to a silicon substrate suitable for use with RF components, and to one or more RF components formed on such a silicon substrate.

### Background

It is known that components, such as micro-electro-mechanical systems (MEMS) switches can be used, in some instances, as replacements for electromechanical relays or solid state switches in radio frequency applications.

Such switches have generally been formed on high resistivity silicon wafers, such as float zone wafers. Float zone (FZ) wafers have a low oxygen content. These wafers give high resistivity which is stable throughout subsequent processing steps. However float zone wafers are expensive in comparison with the standard resistivity Czochralski, CZ, wafer. In addition, the low oxygen content of the float zone wafers gives the wafers poor yield strength making them fragile and prone to breaking in wafer handling tools. Thus their improved electrical performance comes with processing problems and increased expense. Other RF components such as filters, couplers and transmission lines may also benefit from use of a higher resistivity substrate.

### Summary

This disclosure relates to a silicon substrate, comprising a silicon structure formed by the Czochralski process, and having a carrier life time killing layer deposited on the silicon structure.

The structure may be in the form of a wafer. The wafer is formed by slicing/cutting a crystal that was formed using the Czochralski process.

The carrier life time killing layer may be formed by depositing a further layer of material on the silicon structure, such as a wafer, or by suitable doping of an upper region of the wafer.

Preferably the carrier lifetime killing layer is a layer of polysilicon deposited over the silicon structure. Preferably the polysilicon layer is undoped. Very low doping levels may be permissible, in which case the polysilicon can be considered as being substantially undoped. However, other carrier lifetime killing techniques may also be used, in place of or in addition to the formation of the polysilicon layer. Thus doping with impurities such as gold, platinum and so on may also be performed to form the carrier lifetime killing layer. Aluminum Oxide and/or Silicon Nitride may also be used to reduce carrier lifetimes.

The carrier life time killing layer may also function as a passivation over the surface of the silicon layer. However, a further layer of oxide, such as silicon dioxide, may be formed over the carrier life time killing layer.

It is thus possible to provide a polysilicon layer or layer of other material that acts as a carrier lifetime killer. This has the effect of preventing the formation of parasitic conduction layers that might occur subsequent to the deposition of an oxide layer over the passivation.

A further aspect of this disclosure relates to the formation of a RF component for use in a frequency range of around or above 1GHz, for example between one and several GHz or tens of GHz. Such a component may be a micromechanical switch for the switching of signals in a signal path. The component may also be a transmission line, a filter, a signal combiner, a signal splitter, a RLC network, a coupler such as directional coupler, or another RF component.

According to a further aspect of this disclosure, there is provided a method of forming a substrate, the method comprising receiving a doped semiconductor wafer formed by the Czochralski process, and depositing a layer of undoped polysilicon over a surface of the wafer.

### Brief Description of the Drawings

Figure 1 is a cross-section of a micro-machined switch formed over a semiconductor substrate;
Figure 2 is a cross section of a switch formed over a substrate having a carrier life time killing layer formed therein;
Figure 3 is a schematic view of a co-planar waveguide (CPW) formed over a CZ silicon wafer having a carrier life time killing layer formed thereon;
Figure 4 is a graph showing propagation loss in a signal path formed over P-type and N type CZ silicon substrates, comparing situations where a polysilicon layer has been provided and has been omitted; and
Figure 5 is a plot showing substrate resistivity as a function of depth for wafers that have received a thermal treatment designed to replicate the processing history experienced by the substrates during subsequent processing for the manufacture of, for example, a micro-machined switch.

### DETAILED DESCRIPTION OF THE PREFERRED EMBODIMENT

The inventors have found that adding a layer that acts as a carrier lifetime killer, thereby reducing the instance of thermally generated carriers (holes or electrons) within the semiconductor substrate significantly increases the resistivity of the relatively low cost CZ wafer such that it has sufficiently high resistivity to be used within an RF application. Thus, such an application might be the provision of a MEMS switch operating at several GHz, for example in the 1 to 6 GHz range, or at other ranges in the GHz frequency space.

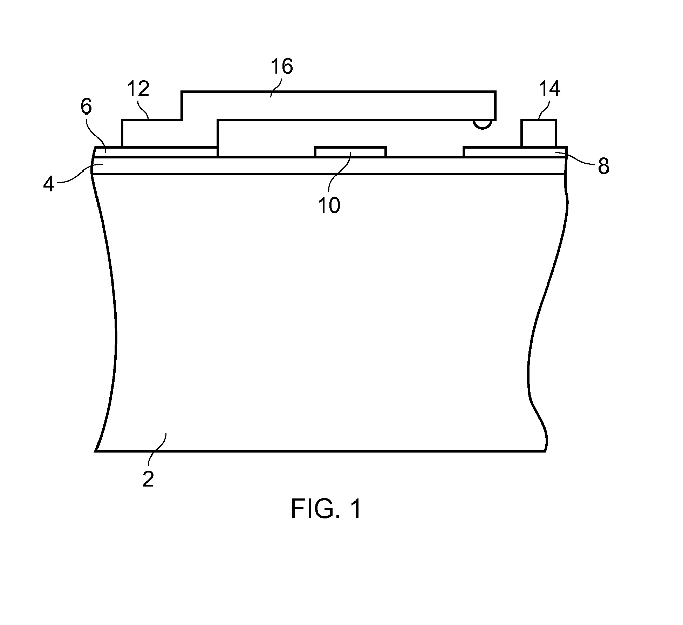

Figure 1 is a schematic cross section through a known MEMS switch, for example of the type described in the paper "fully integrated, high yielding, high reliability DC contact MEMS switch technology and control IC in standard plastic packages" by Goggin, Fitzgerald, Wong, Hecht and Schirmer (available on the internet at World Wide Web page wirelesslab.ie/assets/29/559291CB-A574-CE73-29BDCB86F8F88795_document/ADI_ Dec2011_RG_Fully_integrated_high_yielding_high_reliability_DC_contact_MEMS_switc h_technology_control_IC_in_standard_plastic_packages_finalabstract_.pdf). The switches described therein are fabricated on high resistivity silicon wafers, generally indicated in Figure 1 by reference numeral 2. Such a high resistivity wafer is available as a float zone wafer. A dielectric layer 4, for example of Aluminium oxide, is formed above the wafer 2. Then as known to the person skilled in the art and as described in the above referenced paper, a metal layer is deposited and patterned above the dielectric layer. The patterning on the metal layer acts to form the input and outputs of the switch, which are sometimes referred to as the source and the drain, thereby mimicking the terminology used in respect of field effect transistors, and a control electrode, which is sometimes referred to as a gate. In the arrangement shown in Figure 1, the metal region 6 forms the source, metal region 8 forms the drain and metal region 10 forms the gate. Next, a first layer of gold is deposited to form regions 12 and 14 on opposing sides of the switch. The space between the regions 12 and 14 is then infilled by a sacrificial layer which will be subsequently masked and etched out. Then a second gold region is deposited and patterned so as to form a cantilever 16. Once this has been done the sacrificial layer can be etched away to yield the structure shown in Figure 1. The regions 12 and 14 can then act as bonding pads for a cap wafer (shown in the above referenced paper), which may also be of silicon, which is applied over the cantilever so as to encapsulate it within a chamber. The chamber may, for example, be evacuated although more usually the chamber is used to hermetically seal the switch contacts and cantilever within an inert gas at atmospheric pressure. The switch shown in Figure 1, based on that described in the paper referenced above, had a cantilever with a contact gap of 0.3 microns and an actuation gap of 0.6 microns. The cantilever beam was approximately 6 microns thick and yielded a restoring force of approximately 50 µN (micro Newtons) per contact. As noted before, the device operation is analogous to that of a mechanical field effect transistor. The device shown in Figure 1 was arranged to close when the gate voltage was approximately 50 volts compared to the source voltage, and in use is typically overdriven to 80 volts. Each beam or cantilever 16 is approximately 90 microns long with anchor points approximately 200 microns wide and with five contact points (not shown in Figure 1). Such an arrangement yields a switch with an on state resistance Ron of around 1.5 Ω.

The cap wafer can be adhered to the wafer 2 using a glass frit or similar technology for wafer to wafer bonding.

In testing, such a switch was able to yield a bandwidth of greater than 11 GHz and an insertion loss of less than 0.5 dB up to 7.5 GHz and off isolation in excess of 25 dB up to 6.5 GHz. Thus the processes for forming the switch components are available to the person skilled in the art and are reliable.

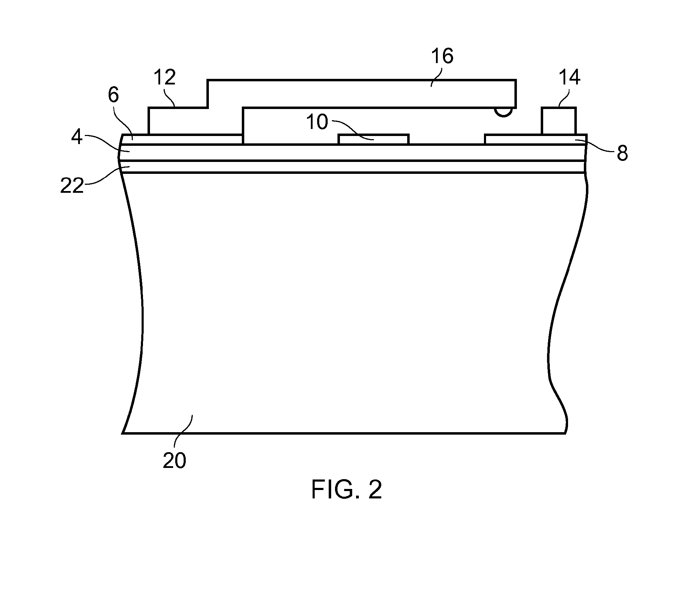

However, the switch arrangement shown in Figure 1 still relies on high resistivity wafers which, as mentioned hereinbefore, are more fragile and more expensive than standard CZ wafers. It also employs an alumina passivation layer whilst silicon dioxide would be the passivation material of preference. Use of silicon dioxide greatly enhances the integration of the process permitting, for example, the subsequent formation of planarized resistors and interconnects. The inventors realized that the arrangement of Figure 1 could be modified, as shown in Figure 2 where like parts are represented by like reference numerals. The float zone wafer 2 of Figure 1 has been replaced by the much more robust and less costly wafer produced by the CZ wafer process, and the CZ wafer is indicated 20. The CZ wafer is topped by a layer 22 which acts to inhibit the formation of parasitic conduction layers at the surface of the wafer 20, and thereby serves as a carrier lifetime killer. The layer 22 acts as a passivation, and in this example is formed of undoped polysilicon. The undoped polysilicon reduces surface conduction at the surface of the CZ wafer 20 induced by the fixed charge associated with the preferred dielectric; namely silicon dioxide. The layer 22 may, for example, be around 0.2 microns thick. Such a thickness is presented by way of illustration only and other thicknesses are possible, for example in the range of 10 nm to 1000 nm. The dielectric layer 4 may be formed of silicon dioxide, although other materials are not excluded from use. The layer 4 can be deposited over a range of thicknesses. Typical thicknesses may be 50 nm to 10000 nm.

The person skilled in the art has various techniques in order to distinguish between CZ and FZ wafers. One such identifier is the concentration of interstitial oxygen. FZ silicon has an oxygen concentration of <0.5 ppma (parts per million atoms) whereas for CZ silicon is generally >10 ppma. Interstitial oxygen concentration can be measured by IR absorption (typically at 9.03 µm or 5.81 µm). Another approach is to measure the facture strength of the wafer as CZ wafers are more robust and fracture less easily. Techniques for measuring fracture strength (such as the 3 point bending method) are known and need not be described here.

The processes described here need not be restricted solely to MEMS switches. Thus a substrate can also be used to form waveguides and filters using transmission line technologies including, for example, co-planar waveguides. The formation of such components in transmission lines is well known to the person skilled in that particular art and will not be described further here. It should be noted that the co-planar waveguides may also be shielded by the provision of conductors running substantially perpendicular to the direction of the strip line conductors, and separated there from by a further layer of oxide.

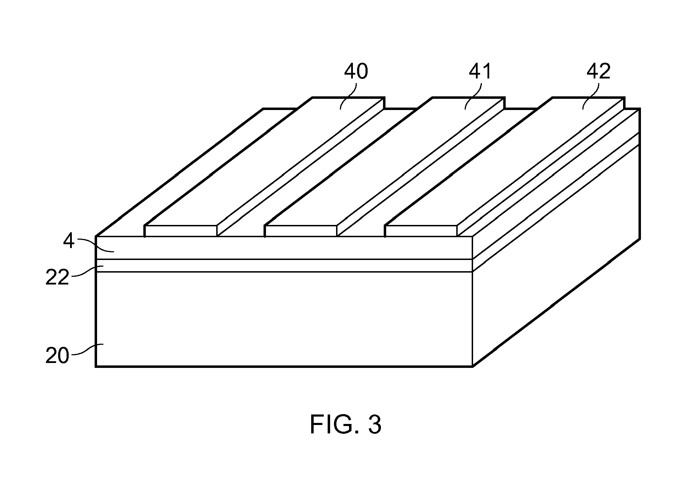

An example of a coplanar waveguide is shown in Figure 3. Here several conductors, labelled 40, 41 and 42 are arranged in parallel such that a signal fed to conductor 41 can propagate between adjacent ground planes 40 and 42 as is known to the person skilled in the art. The co-planar waveguide configuration is formed above a wafer which, as described hereinbefore with respect to Figure 2, comprises a CZ substrate 20 with a thin layer of undoped polysilicon passivation 22 formed thereon, above which a further dielectric layer 4, such as silicon oxide, has been formed.

The thickness of the dielectric or oxide 4 may be varied to control the characteristic impedance of the wafer, in measurements in the range of 0 to 10 GHz, an oxide thickness of approximately 2 microns gave a characteristic impedance of around 30 Ω at 2 GHz rising gently to about 42 Ω at 10 GHz, whereas an oxide thickness of 8 microns gave an impedance of around 50 Ω at 2 GHz which maintained a substantially steady value across the frequency range, rising to about 58 Ω at 10 GHz. Thus this is readily compatible with RF circuits and components expecting a nominal impedance of 50 Ω.

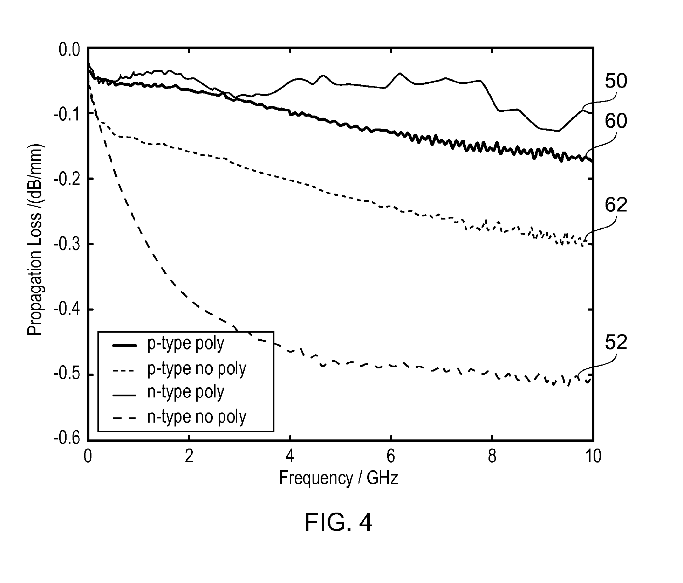

Figure 4 is a graph showing propagation loss for a metallic signal carrying path formed over a high resistivity CZ wafer 20 of the type used in the formation of integrated circuits.

The propagation loss in decibel per millimeter is plotted against frequency in GHz for:
a) a P-type silicon substrate with an undoped polysilicon layer formed over the substrate, and represented by line 60;
b) a P-type silicon substrate without a polysilicon layer, and represented by line 62;
c) a N-type silicon substrate with an undoped polysilicon layer having been formed thereon, as represented by line 50; and
d) a N-type silicon substrate without a polysilicon layer, and represented by line 52.

The graph show that the inclusion of the undoped polysilicon layer over a wafer formed by the CZ process provides a significant reduction in propagation loss compared to wafers not having a polysilicon layer.

The data shown in Figure 4 was gathered before performing a heat treatment (thermal anneal) step which would be expected in a finished device (so as to mimic the temperature cycle of a wafer bonding step).

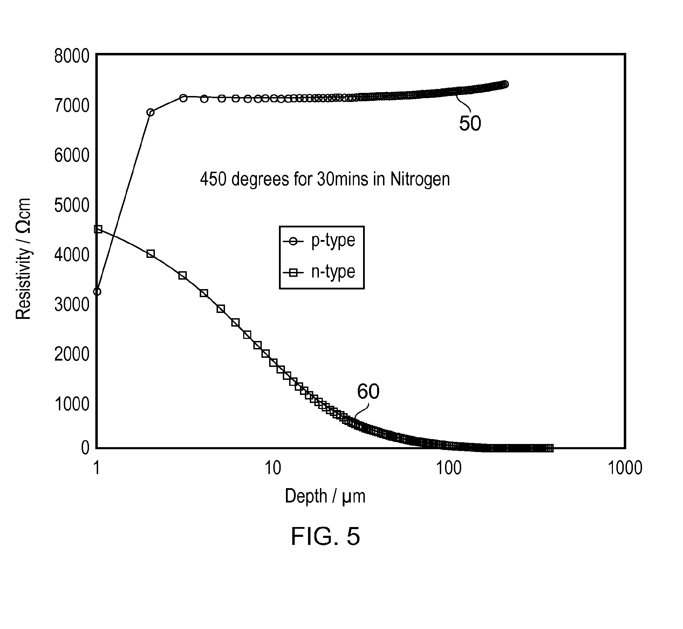

Figure 5 is a plot showing resistivity of the substrate as a function of depth from the polysilicon layer following a thermal anneal at 450oC for 30 minutes in a Nitrogen atmosphere. The P-type substrate 60 with the undoped polysilicon layer maintains a high resistivity as a function of depth, whereas the N-type substrate 50 (with the polysilicon layer) has a resistivity that rapidly drops as a function of depth. It is noted that both substrates exhibit high resistivity in the first few microns from the surface, but given the bulk properties shown in Figure 5, a P-type substrate gives better performance.

It is thus possible to provide acceptable RF performance in the GHz range using components formed over the CZ wafer, where such a wafer has been processed to include a carrier lifetime killing layer at its surface. Such a CZ wafer may have a resistivity in a range of 3000 to 30000Ωcm. This enables the cheaper and more robust CZ technology to be used in foundries which are generally designed to be used with this wafer type. Thus the risk of breakage of a wafer during handling is much reduced, and hence the yield is increased, as is profitability or alternatively cost to the customer can be decreased.

It is also noted that in some embodiments the avoidance of alumina passivation layer (for example substitution with a silicon dioxide layer) and use of a polysilicon layer may also be employed with Float Zone silicon to provide some advantages in subsequent device processing steps.

As noted before, high resistivity substrates can be used in conjunction with other RF microelectronic components such as filers (resistor/capacitor/inductor or micro strip), couplers (directional or otherwise) and other RF components. Such components may be provided in a package and be regarded as a "chip".

Whilst use of undoped polysilicon has been discussed, small or trace levels of doping may be acceptable without degrading performance.

While certain embodiments have been described, these embodiments have been presented by way of example only, and are not intended to limit the scope of the disclosure. Indeed, the novel systems, apparatus, and methods described herein may be embodied in a variety of other forms. Furthermore, various omissions, substitutions and changes in the form of the methods and systems described herein may be made without departing from the spirit of the disclosure. The accompanying claims and their equivalents are intended to cover such forms or modifications as would fall within the scope and spirit of the disclosure. Accordingly, the scope of the present inventions is defined by reference to the claims.

## Claims

1. A silicon substrate, comprising a silicon structure (20) formed by the Czochralski process, and having a carrier life time killing layer (22) deposited on the silicon structure.

2. A silicon substrate as claimed in claim 1, in which the silicon structure has a resistivity of around 3000 to 30000 Ωcm.

3. A silicon substrate as claimed in claim 1 or 2, in which the carrier lifetime killing layer is a polysilicon layer.

4. A silicon substrate as claimed in claim 3, in which the polysilicon has a thickness of between 10 nm and 1000 nm.

5. A silicon substrate as claimed in claim 3, in which the polysilicon is undoped or substantially undoped.

6. A silicon substrate as claimed in any preceding claim, further comprising a radio frequency component formed over the carrier lifetime killing layer.

7. A silicon substrate as claimed in claim 6, in which the radio frequency component comprises a micro-machined electromechanical switch.

8. A silicon substrate as claimed in claim 7, in which the switch is formed over a dielectric layer.

9. A silicon substrate as claimed in claim 8, in which the dielectric layer is between 50nm and 10000nm thick.

10. A silicon substrate including a radio frequency component as claimed in claim 6, in which the radio frequency component is at least one of a transmission line, a filter, a signal combiner, a signal splitter, a RLC network and a directional coupler.

11. A method of providing a semiconductor substrate for use in the formation of components operating in excess of 1 GHz, comprising forming a carrier life time killing layer over a wafer formed by the CZ process.

12. A method as claimed in claim 11, in which forming a carrier life time killing layer comprises depositing a layer of substantially undoped polysilicon over the semiconductor substrate prior to an annealing step.

13. A method of fabricating a device, comprising forming an electronic component on a semiconductor substrate where the substrate was formed by the CZ process and has a carrier life time killing layer over the substrate, and optionally where the electronic component comprises an RF MEMS switch, a transmission line, a filter, a signal combiner, a signal splitter, a RLC network or a directional coupler.

14. A silicon substrate having a polysilicon layer formed thereon.

15. A silicon substrate as claimed in claim 15, in which the silicon substrate is float zone silicon, or Czochralski silicon; and/or further including a radio frequency component formed over the carrier lifetime killing layer.
